Europäisches Patentamt

European Patent Office

Office européen des brevets

(11) Publication number: **0 195 865 B1**

# EUROPEAN PATENT SPECIFICATION

(45) Date of publication of patent specification: **03.06.92** (51) Int. Cl.⁵: **H01R 23/70**, H01R 13/64

(21) Application number: **85306896.3**

(22) Date of filing: **27.09.85**

(54) Insertion device connector for, and ic card.

(30) Priority: **25.03.85 JP 42966/85 U**

(43) Date of publication of application:
**01.10.86 Bulletin 86/40**

(45) Publication of the grant of the patent:
**03.06.92 Bulletin 92/23**

(84) Designated Contracting States:
**DE FR GB**

(56) References cited:
**EP-A- 0 018 116**
**US-A- 3 024 436**

(73) Proprietor: **MIPS CO., LTD.**
**1-12-14 Koishikawa Bunkyo-ku**
**Tokyo 112(JP)**

(72) Inventor: **Hamada, Yoshitaka**
**13, 2-ban, 6-chome, Ikuta Tama-ku**
**Kawasaki-shi Kanagawa-ken(JP)**

(74) Representative: **Brunner, Michael John et al**
**GILL JENNINGS & EVERY 53-64 Chancery**
**Lane**
**London WC2A 1HN(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

Rank Xerox (UK) Business Services

## Description

The invention relates to a semiconductor integrated circuit card electronic insertion device.

An IC card electronic insertion device provides equipment in which information can be electrically transferred between the circuitry on the electronic equipment and the IC circuit in the card by inserting an IC card having the desired functions (programs or data) into a card slot in the device. Such equipment is common in personal computers, hand-held computers, TV games machines and other electronic equipment.

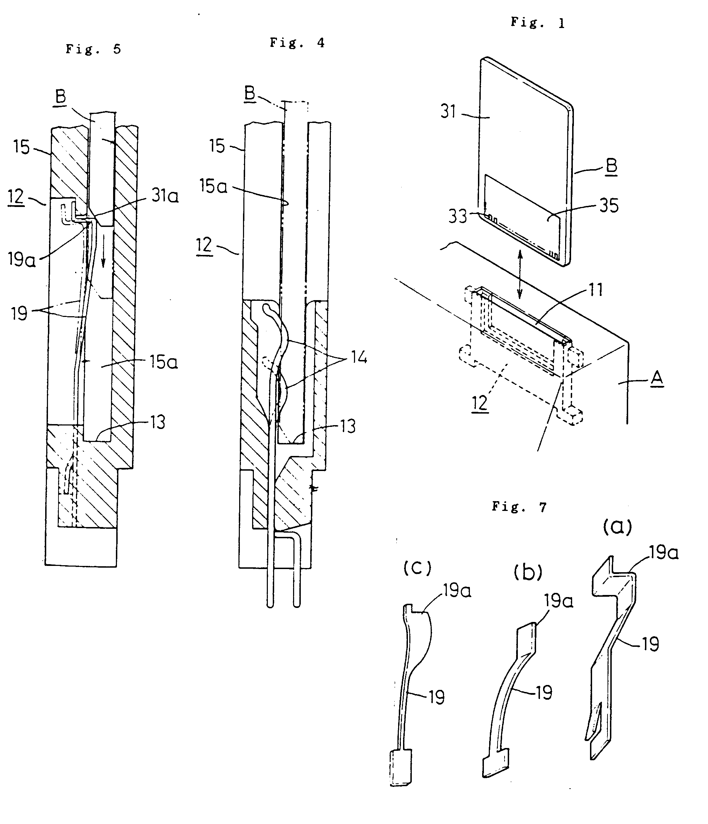

Such equipment is shown in Figures 1, 2 and 4 of the drawings.

An IC card consists of a compact, thin inflexible card body 31 usually measuring about 85.6 mm long, 54 mm wide, and 0.8-2.0 mm thick, in which an IC (integrated circuit) chip 32 having desired functions is built into a rigid or semi-rigid card body made of plastics or reinforced cardboard. Circuit terminals 33 are arranged along a leading edge on the surface of the card.

On an IC card of the prior art, an IC chip 32 is built into the card by inserting a printed circuit board (PCB) 35 with the IC chip 32 into a rectangular hollow 34 positioned near the card edge on the surface of the body 1, with the chip side toward the hollow 34, and by fixing the PCB with adhesive. Metal printed terminals 33, which are arranged along the board edge corresponding to the card edge on the board surface opposite to the IC chip mounting surface, are connected to the chip 32 via corresponding printed wires 36 through holes.

The IC card can be inserted into a card slot 11 on the electronic equipment A, with the card edge having the terminals 33 oriented toward the card slot and with the card's front face (in this example, the surface on which the terminals 33 are arranged) oriented (as shown in Figure 2) towards you, until the card edge bottoms against the insertion end 13 on a connector 12. The terminals 33 are then in full contact with corresponding springy terminals 14 in the device, so that the IC circuit on the card B is electrically connected to the control circuit (not shown in the figure) on the electronic equipment to allow information to be transferred between them.

The connector 12 is a plastic injection moulded product in which spring terminals 14 are moulded at predetermined positions and intervals corresponding to the terminals 33 on the card. Guide rails 15 having a U-shaped cross-section are arranged in parallel and in opposition to each other at the left and right sides of the connector. The left and right edges of the card are inserted into the grooves 15a-15a in the left and right guide rails 15-15 so that the card is smoothly guided. Attachment lugs 16,17 for securing the connector 12 to the side plate 18 on the electronic equipment body are provided.

When such an IC card is inserted into the card slot 11 on the electronic equipment, the specified card edge and the specified card surface must both be correctly oriented for correct usage. The card can often be inserted by mistake incorrectly oriented. In this case, of course, the IC circuit on the card cannot be connected to the circuit on the electronic equipment; in addition, the terminals 14 on the connector 12 and/or the edge and surfaces of the card may be damaged. With some types of connectors, a card which has been inserted incorrectly cannot be pulled out, or becomes hard to pull out. If it is forcefully pulled out, the connector terminals or the card may be damaged.

An object of the present invention is to prevent incorrect insertion of an IC card which may cause trouble such as damage to the connector terminals.

It is known (see EP-A-0018116), in connection with a printed circuit card for a data memory, to prevent insertion of the card into the wrong card slot in the memory device or inverted insertion of the card, by providing each card with a slot in its leading edge, which slots co-operate with corresponding projections to allow insertion into the correct slot or in the correct orientation.

According to a first aspect of the present invention, there is provided an IC card for insertion into a card slot of a connector of an electronic insertion device, the connector having means, for co-operating with the card, to allow the card to be fully inserted to the insertion end of the connector only when the card is inserted into the card slot in the correct orientation with respect to the connector, the card having:

a flat, generally rectangular body;

an integrated circuit chip carried on the body; and,

a plurality of card terminals arranged along an edge of the body for establishing electrical connection with mating connector terminals at the insertion end of the slot; characterised in that:

the card body has a portion with a sloping face for co-operating with said means in a connector in which the card is inserted.

If the card is inserted incorrectly, it is stopped from advancing farther than a position where the card edge does not reach the terminals on the connector. This warns the operator of incorrect card insertion, and prevents trouble such as damage to the connector terminals.

According to a second aspect of the present invention, there is provided a connector for an IC card electronic insertion device having a card slot, and a row of terminals, the connector having means, for co-operating with an IC card as defined above, which allows the IC card to be fully inserted to the insertion end of the connector only when the IC card is inserted into the card slot in the correct orientation with respect to the connector and which stops the card from advancing further at a position where the card terminals do not contact the terminals on the connector if the card is inserted in the incorrect orientation, characterised in that:

the means co-operates with the portion of the card having the sloping face to allow full insertion of the card.

Two embodiments of the invention will now be described with reference to the accompanying drawings, in which:-

Figure 1 illustrates a card slot on a piece of electronic equipment and an IC card which is to be inserted into the slot;

Figure 2 shows a partially cutaway front view of a connector and a front view of the fore edge portion of the IC card which is inserted into the connector;

Figure 3 is a sectional view taken along the line III-III of Figure 2;

Figure 4 is an enlarged sectional view taken along the line IV-IV of Figure 2;

Figure 5 is an enlarged sectional view taken along the line V-V of Figure 2;

Figures 6(a) and 6(b) are partial sectional plan views of the card inserted with the card face oriented incorrectly and the card inserted in the opposite direction, respectively;

Figures 7(a), 7(b) and 7(c) illustrate the examples of the shape of the spring member; and,

Figure 8 illustrates the major portions of another embodiment of the invention.

A is part of the electronic equipment; B is an IC card; 11 is an insertion slot; 12 is a card insertion connector; 14 are connector terminals; and 33 is a terminal on the card. In figures 1 to 7, the leading fore edge of the IC card B includes a cam face 31a of slanting or arcuate shape.

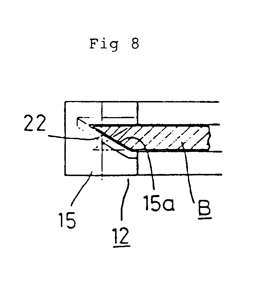

On the connector 12, spring members 19-19 are positioned, which are formed by bending spring plates (see Figure 7). The projections 19a-19a of the spring members 19-19 stand out in the grooves 15a-15a of the left and right guide rails 15-15 at a position between the card slot 11 and the terminal position.

When the IC card B is inserted to the card slot 11 on the connector 12 with the card edge in the correct direction and with the card face oriented correctly (Fig.5) the cam face 31a on the card edge comes in contact with the projections 19a-19a of the spring members 19-19 in the grooves on the connector 12. When the card is pressed in further, the cam face 31a moves the projections 19a-19a of the spring members 19-19 outward against a spring force produced by the spring member (Fig.5 - shown by the two-dot chain line). This action allows the card B to bottom at the insertion end 13 of the connector 12.

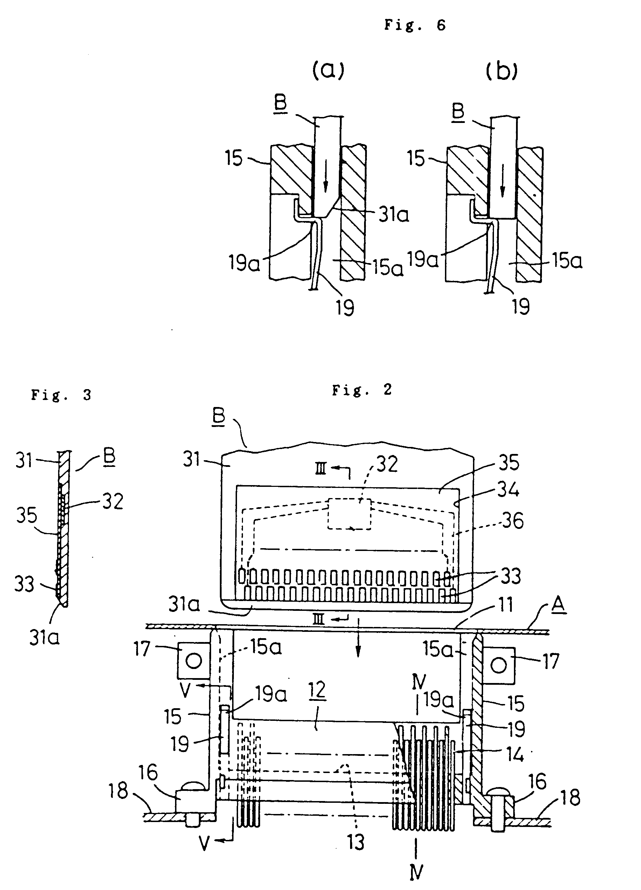

If the card B is inserted with the card face oriented incorrectly (Fig.6(a)) or with the card edge in the opposite direction (Fig.6(b)), the cam face 31a does not come into contact with the projection 19a-19a of the spring members 19-19, so that the projections cannot be moved outward. Therefore, the edge of the inserted card is held by the projections 19a-19a of the spring members 19-19 to prevent the card edge from reaching the terminals on the connector. The spring members 19-19 may be metal or plastic pieces of a shape shown in Figs.7(a)-7(c), or may be moulded integrally during injection moulding of the connector.

In a second embodiment (see Fig.8), either or both left and right side edges of the card B are bevelled into a wedge shape 22 over a part of their length and the cross-section of the groove 15a of the guide rail 15 on the connector 12 is so shaped that the groove 15a accommodates the bevelled side edge of the card B (shown by solid line) to allow the card's leading edge to reach the insertion end 13 on the connector when the card is inserted correctly, whereas the groove 15a does not accommodate the bevelled side edges of the card B (shown by two-dot chain line) when the card is inserted incorrectly. Only the upper portion of guide rail 15a or the card slot 11 may be so shaped as to accommodate the bevelled side edge of the card B only when the card is inserted correctly.

## Claims

1. An IC card (B) for insertion into a card slot (11) of a connector (12) of an electronic insertion device, the connector having means (19a), for co-operating with the card, to allow the card (B) to be fully inserted to the insertion end (13) of the connector (12) only when the card (B) is inserted into the card slot (11) in the correct orientation with respect to the connector (12), the card having:

a flat, generally rectangular body (31);

an integrated circuit chip (32) carried on the body; and,

a plurality of card terminals (33) arranged along an edge of the body for establishing electrical connection with mating connector terminals (14) at the insertion end of the slot; characterised in that:

the card body has a portion with a sloping face (31a,22) for co-operating with said means (19a) in a connector in which the card is inserted.

2. An IC card (B) according to claim 1, wherein the sloping face is a cam face (31a) at the edge of the card (B) at which the card terminals are disposed, for co-operation with an abutment (19a) in the connector.

3. An IC card (B) according to claim 1, wherein the sloping face is a bevel (22) over a part of the length of one or both of the opposite side edges of the card.

4. An IC card (B) according to any of claims 1 to 3, wherein the card terminals are arranged in rows with the terminals in the respective rows being offset from one another.

5. A connector (12) for an IC card electronic insertion device having a card slot (11), and a row of terminals (14), the connector having means (19a), for co-operating with an IC card (B) according to any of claims 1 to 4, which allows the IC card (B) to be fully inserted to the insertion end (13) of the connector (12) only when the IC card (B) is inserted into the card slot (11) in the correct orientation with respect to the connector (12) and which stops the card from advancing further at a position where the card terminals (33) do not contact the terminals (14) on the connector (12) if the card is inserted in the incorrect orientation, characterised in that:
the means (19a) co-operates with the portion of the card having the sloping face to allow full insertion of the card.

6. A connector according to claim 5, wherein the said means (19a) in the connector comprises an abutment (19a) at a position between the card slot (11) and the connector terminals (14) which is spring biased and can be moved by a cam face (31a) on the card against the bias to allow the card edge to reach the insertion end (13) only when the card is correctly inserted.

7. A connector according to claim 5, for use with a card (B) which has opposite side edges at least one of which has a bevel over part of its length, the connector (12) having a pair of guide rails (15) which are profiled (15a) accordingly to match the bevel of the edge or edges of the card (B) to ensure correct insertion.

8. A connector according to any of claims 5 to 7, characterised in that the connector terminals (14) are arranged in rows with the terminals in the respective rows being offset with respect to one another.

**Revendications**

1. Carte CI destinée à son insertion dans une fente à carte (11) d'un connecteur (12) d'un dispositif d'insertion électronique, le connecteur comprenant des moyens (19a) pour coopérer avec la carte et permettre à cette carte (B) de n'être insérée en totalité jusqu'à l'extrémité d'insertion (13) du connecteur (12) que lorsque la carte (B) est insérée dans la fente à carte (11) selon l'orientation correcte par rapport au connecteur (12), la carte comprenant:
un corps plat et généralement rectangulaire (31);
une puce à circuit intégré (32) supportée sur le corps; et
une pluralité de bornes (33) de carte disposées le long d'un bord du corps pour établir la connexion électrique avec des bornes (14) d'un connecteur qui leur correspondent à l'extrémité d'insertion de la fente; caractérisée en ce que:
le corps de la carte comprend une portion à face inclinée (31a, 22) pour coopérer avec lesdits moyens (19a) dans un connecteur dans lequel la carte est insérée.

2. Carte CI (B) selon la revendication 1, dans laquelle la face inclinée est une face à came (31a) sur le bord de la carte (B) sur laquelle sont disposées les bornes de la carte, pour coopérer avec une butée (19a) du connecteur.

3. Carte CI (B) selon la revendication 1, dans laquelle la face inclinée est un biseau (22) prévu sur une partie de la longueur de l'un ou des deux bords latéraux opposés de la carte.

4. Carte CI (B) selon l'une quelconque des revendications 1 à 3, dans laquelle les bornes de la carte sont disposées en rangées, les bornes des rangées respectives étant décalées les unes par rapport aux autres.

5. Connecteur (12) pour un dispositif d'insertion électronique d'une carte CI comprenant une fente à carte (11) et une rangée de bornes, le connecteur comportant des moyens pour coopérer avec une carte CI (B) selon l'une quelconque des revendications 1 à 4, qui permettent à la carte CI (B) de n'être insérée en totalité jusqu'à l'extrémité d'insertion (13) du connecteur (12) que lorsque la carte CI (B) a été insérée dans la fente à carte (11) selon l'orientation correcte par rapport au connecteur (12), et qui empêchent la carte de continuer d'avancer dans une position où les bornes (33) de la carte ne sont pas en contact avec les bornes (14) du connecteur (12) si la carte est insérée selon une orientation incorrecte, caractérisé en ce que:

les moyens (19a) coopèrent avec la portion de la carte dont la face est inclinée pour permettre l'insertion totale de la carte.

6. Connecteur selon la revendication 5, dans lequel lesdits moyens (19a) du connecteur comprennent une butée (19a), dans une position située entre la fente à carte (11) et les bornes (14) du connecteur, qui est sollicitée élastiquement et peut être déplacée par une face à came (31a) de la carte à l'encontre de la sollicitation pour permettre au bord de la carte de n'atteindre l'extrémité d'insertion (13) que lorsque la carte est correctement insérée.

7. Connecteur selon la revendication 5, destiné à être utilisé avec une carte (B) comprenant des bords latéraux opposés dont l'un au moins comprend un biseau sur une partie de sa longueur, le connecteur (12) comprenant une paire de rails de guidage (15) qui sont profilés (15a) de façon à être adaptés au biseau du bord ou des bords de la carte (B) pour assurer une insertion correcte.

8. Connecteur selon l'une quelconque des revendications 5 à 7, caractérisé en ce que les bornes (14) du connecteur sont disposées en rangées, les bornes des rangées respectives étant décalées les unes par rapport aux autres.

**Patentansprüche**

1. Eine Karte (B) mit einer integrierten Schaltung zum Einsetzen in einen Kartenschlitz (11) einer Anschlußeinheit (12) einer elektronischen Einsteckvorrichtung, wobei die Anschlußeinheit Mittel (19a) zum Zusammenwirken mit der Karte aufweist, um das vollständige Einstecken der Karte (B) bis zum Einsteckende (13) der Anschlußeinheit (12) nur dann zu gestatten, wenn die Karte (B) in den Kartenschlitz (11) in der korrekten Orientierung im Vergleich zu der Anschlußeinheit (12) eingesteckt ist, wobei die Karte

einen flachen, im wesentlichen rechteckigen Körper (31),

einen Chip (32) als integrierte Schaltung, der von dem Körper aufgenommen wird, und

eine Mehrzahl von Kartenkontakten (33) aufweist, die entlang einer Kante des Körpers zur Herbeiführung einer elektrischen Verbindung mit dazu passenden Anschlußkontakten (14) an dem Einsteckende des Schlitzes angeordnet sind, dadurch **gekennzeichnet, daß:**

der Kartenkörper einen Abschnitt mit einer schrägen Fläche (31a, 22) für das Zusammenwirken mit den Mitteln (19a) in einer Anschlußeinheit aufweist, in die die Karte eingesteckt wird.

2. Eine Karte (B) mit integriertem Schaltkreis nach Anspruch 1, bei der die schräge Fläche eine Verschiebefläche (31a) an der Kante der Karte (B) ist, an der die Kartenkontakte angeordnet sind, zum Zusammenwirken mit einem Vorsprung (19a) in der Anschlußeinheit.

3. Eine Karte (B) mit integrierter Schaltung nach Anspruch 1, bei der die schräge Fläche eine Abschrägung (22) über einen Teil der Länge einer oder beider sich gegenüberliegende Seitenkanten der Karte ist.

4. Eine Karte (B) mit integrierter Schaltung nach einem der Ansprüche 1 bis 3, bei der die Kartenkontakte in Reihen angeordnet sind, wobei die Kontakte einer Reihe gegenüber denen einer anderen Reihe versetzt angeordnet sind.

5. Eine Anschlußeinheit (12) für eine elektronische Einsteckvorrichtung für eine Karte mit integrierter Schaltung, die einen Kartenschlitz (11) und eine Reihe von Kontakten (14) hat, wobei die Anschlußeinheit Mittel (19a) zum Zusammenwirken mit einer Karte (B) mit integrierter Schaltung nach einem der Ansprüche 1 bis 4 aufweist, welche Mittel das vollständige Einstecken der Karte (B) mit integrierter Schaltung bis zum Einstecken (13) der Anschlußeinheit (12) nur dann gestatten, wenn die Karte (B) mit integrierter Schaltung in den Kartenschlitz (11) in der korrekten Orientierung im Vergleich zu der Anschlußeinheit (12) eingesteckt ist, und welche die Karte an einer Stelle an einem weiteren Einwärtsweg hindern, an der die Kartenkontakte (33) nicht die Kontakte (14) der Anschlußeinheit (12) berühren, wenn die Karte in der falschen Orientierung eingesteckt wird, dadurch **gekennzeichnet, daß**

die Mittel (19a) mit dem Abschnitt der Karte zusammenwirken, der die schräge Fläche aufweist, um das vollständige Einstecken der Karte zu gestatten.

6. Eine Anschlußeinheit nach Anspruch 5, bei der die Mittel (19a) in der Anschlußeinheit einen Vorsprung (19a) an einer Stelle zwischen dem Kartenschlitz (11) und den Anschlußeinheitskontakten (14) umfassen, der unter Federvorspannung steht und mit Hilfe einer Verschiebefläche (31a) an der Karte gegen die Vorspannung bewegbar ist, um das Erreichen des Einsteckendes (13) der Kartenkante nur dann zu gestatten, wenn die Karte korrekt eingesteckt ist.

7.  Eine Anschlußeinheit nach Anspruch 5 zum Einsatz mit einer Karte (B), die sich gegenüberliegende Seitenkanten aufweist, von denen zumindest die eine eine Abschrägung über einen Teil ihrer Länge aufweist, wobei die Anschlußeinheit (12) ein Paar von Führungsschienen (15) hat, die entsprechend profiliert (15a) sind, um der Abschrägung der Kante oder Kanten der Karte (B) zu entsprechen, um das richtige Einstecken sicherzustellen.

8.  Eine Anschlußeinheit nach einem der Ansprüche 5 bis 7, dadurch **gekennzeichnet,** daß die Anschlußeinheitsanschlüsse (14) in Reihen angeordnet sind, wobei die Kontakte der einen Reihe gegenüber denen der anderen Reihe versetzt angeordnet sind.

Fig. 5

Fig. 4

Fig. 1

Fig. 7

(a)

(c)          (b)

Fig. 6

(a)                     (b)

Fig. 3          Fig. 2

Fig 8